# EUROPÄISCHE PATENTSCHRIFT

(11) **EP 3 499 588 B1**
(45) Veröffentlichungstag und Bekanntmachung des Hinweises auf die Patenterteilung: **20.11.2019**
(21) Anmeldenummer: 18000952.4
(22) Anmeldetag: 10.12.2018
(51) Int. Cl.: H01L 31/167, H01L 31/0687, H01L 31/0693, H01L 31/0304, H01L 31/02

(54) **OPTISCHE SPANNUNGSQUELLE**
OPTICAL VOLTAGE SOURCE
SOURCE DE TENSION OPTIQUE

(30) Priorität: 15.12.2017 DE 102017011643
(43) Veröffentlichungstag der Anmeldung: 19.06.2019
(73) Patentinhaber: AZUR SPACE Solar Power GmbH, 74072 Heilbronn (DE)
(72) Erfinder: Keller, Gregor, 74080 Heilbronn (DE); Fuhrmann, Daniel, 74081 Heilbronn (DE)
(74) Vertreter: Koch Müller Patentanwaltsgesellschaft mbH

(56) Entgegenhaltungen:
- EP-A2- 1 936 700
- CN-Y- 201 393 213
- EMELYANOV VIKTOR M. ET AL: "Photovoltaic optical sensors for high-power conversion and information transmission", PROC. OF SPIE, Bd. 10231, 16. Mai 2017 (2017-05-16), Seite 102311B, XP060090759, DOI: 10.1117/12.2264083 ISBN: 978-1-5106-1533-5
- ISHIGAKI MASANORI ET AL: "A new optically-isolated power converter for 12 V gate drive power supplies applied to high voltage and high speed switching devices", 2017 IEEE APPLIED POWER ELECTRONICS CONFERENCE AND EXPOSITION (APEC), IEEE, 26. März 2017 (2017-03-26), Seiten 2312-2316, XP033098590, DOI: 10.1109/APEC.2017.7931022 [gefunden am 2017-05-17]

## Beschreibung

Die Erfindung betrifft eine optische Spannungsquelle.

Zur Versorgung von Sensoren in exponierten Umgebungen, z.B. aufgrund von Hochspannung oder Explosionsgefahr, ist es bekannt, die Energie optisch zu Übertragen und beispielsweise mit einem photovoltaischen Konverter in elektrische Energie umzuwandeln. Hierfür werden optische Spannungsquelle mit einer möglichst hohen Ausgangsspannung benötigt, z.B. eine Hochvoltdiode, wie sie aus der EP 2 983 213 A1 bekannt ist.

Aus der Dissertation "Gestapelte PIN-Dioden und Resonanztunneldioden in optoelektronischen Empfängerschaltungen hoher Funktionsdichte", von Arthur Christoph Poloczek, 1. Aufl., 2011 ist eine optoelektronische Empfängerschaltung mit hoher Funktionsdichte offenbart.

Aus Emelyanov Viktor M.Et al: "Photovoltaic optical sensors for high-power conversion and information transmission", Proc. of Spie, Vol. 10231, 16. Mai 2017, Seiten 102311B-1-102311B-12, ISBN: 978-1-5106-1533-5, ist eine Mehrfachsolarzelle zur Leistungsübertragung bekannt.

Aus Ishigaki Masanori et al: "A new optically-isolated power converter for 12 V gate driver power supplies applied to high voltage and high speed switching devices", 2017 IEEE applied power electronics conference and exposition (APEC), 26. März 2017, Seiten 2312-2316, ist eine Schaltung und ein System zur optischen Leistungsübertragung bekannt.

Aus der EP 1 936 700 A2 ist ein Multi-Segment PV Leistungskonverter bekannt. Aus der CN 201 393 213 Y ist eine Anordnung zur optischen Datenübertragung bekannt.

Vor diesem Hintergrund besteht die Aufgabe der Erfindung darin, eine Vorrichtung anzugeben, die den Stand der Technik weiterbildet.

Die Aufgabe wird durch eine optische Spannungsquelle mit den Merkmalen des Patentanspruchs 1 gelöst. Vorteilhafte Ausgestaltungen der Erfindung sind Gegenstand von Unteransprüchen.

Gemäß dem Gegenstand der Erfindung werden eine optische Spannungsquelle und eine Auskoppelvorrichtung bereitgestellt.

Die optische Spannungsquelle weist eine Anzahl N zueinander in Serie geschalteter Halbleiterdiode jeweils mit einem p-n Übergang auf, wobei die Halbleiterdioden zusammen monolithisch integriert sind und gemeinsam einen ersten Stapel mit einer Oberseite und einer Unterseite ausbilden.

Die Anzahl N der Halbleiterdioden des ersten Stapels ist größer gleich zwei.

Die Auskoppelvorrichtung weist eine weitere Halbleiterdiode auf, wobei die weitere Halbleiterdiode einen p-i-n-Übergang umfasst.

Die weitere Halbleiterdiode ist mit den Halbleiterdioden des ersten Stapels anti-seriell verschaltet, wobei eine Unterseite der weiteren Halbleiterdiode mit der Oberseite des ersten Stapels stoffschlüssig verbunden ist und die weitere Halbleiterdiode mit dem ersten Stapel zusammen einen gemeinsamen Gesamtstapel bildet.

Es sei angemerkt, dass die Dioden des ersten Stapels zusammen eine sogenannte Multijunction-Photodiode bzw. eine Hochvoltdiode bilden und die optische Spannungsquelle darstellen.

Es wird somit eine optische, galvanisch isolierte Energieversorgung bereitgestellt. Bevorzugt bestehen die Halbleiterdioden des ersten Stapels und/oder die weitere Halbleiterdiode aus einem III-V-Halbleiter, besonders bevorzugt aus GaAs.

Insbesondere III-V-Halbleiter, wie GaAs, wandeln Licht mit geeigneter Wellenlänge sehr effizient in elektrische Energie um.

Die weitere Diode wird auch als PIN-Diode oder als schnelle Photodiode bezeichnet. Es sei angemerkt, dass die weitere Diode aus mehreren stapelförmigen Halbleiterschichten ausgebildet ist und einen zweiten Stapel ausbildet. Vorzugsweise sind der erste Stapel ST1 und der zweite Stapel ST2 monolithisch integriert.

Durch die anti-serielle Verschaltung der weiteren Diode mit den Halbleiterdioden des ersten Stapels wird die weitere Diode mit einer Quellspannung des ersten Stapels bzw. der optischen Spannungsquelle in Sperrrichtung bzw. Rückwärtsrichtung vorgespannt.

Mittels der negativen Vorspannung, also einem negativen Bias, wird die Kapazität der weiteren Halbleiterdiode minimiert, so dass die weitere Diode in dem Arbeitspunkt im Vergleich zu dem ersten Stapel bzw. der optischen Spannungsquelle eine besonders niedrigere Kapazität aufweist. Hierdurch wird eine schnelle Datenübertragung bzw. ein schnelles Schalten der Photodiode ermöglicht.

Datensignale werden zur Übertragung auf das optische Signal für die Leistungsübertragung aufmoduliert. Alternativ werden Datensignale mittels einer spezifischen Wellenlänge übertragen, wobei sich die spezifische Wellenlänge für die Datenübertragung von allen für die Leistungsübertragung genutzten Wellenlängen unterscheidet.

Erfindungsgemäß wird somit eine Hochvoltdiode als effizienter und galvanisch isolierter Energieversorger mit einer schnellen Leistungsdiode zur Datenübertragung, z.B. von Steuersignalen, kombiniert.

Ein Vorteil der erfindungsgemäßen Kombination ist folglich, dass die Gesamtvorrichtung zusätzlich zu einer galvanisch isolierten Leistungsübertragung eine schnelle Datenübertragung ermöglicht.

In einer alternativen Ausführungsform überdeckt die weitere Halbleiterdiode in einer Projektion senkrecht zu der Oberseite des ersten Stapels höchstens 50% oder höchstens 30% oder höchstens 10% der Oberseite des ersten Stapels.

In einer Weiterbildung weist die weitere Halbleiterdiode eine Kapazität von höchstens 10 pF auf. Hierbei bezieht sich der Kapazitätswert auf eine Betriebsspannung. Vorzugsweise liegt die Betriebsspannung in einem Bereich zwischen 1 Volt und 10 Volt, höchst vorzugsweise in einem Bereich zwischen 2 Volt und 5 Volt.

Gemäß einer anderen Weiterbildung sind die Halbleiterdioden und die weitere Halbleiterdiode zusammen monolithisch integriert.

In einer anderen Ausführungsform ist ein erster Kontakt, z.B. als Kontaktfläche, auf der Oberseite des ersten Stapels angeordnet ist und weist einen Abstand zu der weiteren Diode auf. Bevorzugt ist der erste Kontakt mit einer Kathode der weiteren Halbleiterdiode und mit einer Kathode der an die Oberseite des ersten Stapels angrenzenden Halbleiterdiode elektrisch leitfähig verbunden.

Gemäß einer weiteren Ausführungsform ist ein zweiter Kontakt, z.B. als Kontaktfläche, auf einer Oberseite der weiteren Diode angeordnet ist.

In einer anderen Ausführungsform ist ein dritter Kontakt, z.B. eine Kontaktfläche, auf einer Unterseite des ersten Stapels angeordnet oder die Unterseite des ersten Stapels ist stoffschlüssig mit einer Oberseite eines Trägersubstrats verbunden und ein dritter Kontakt, z.B. eine Kontaktfläche, ist auf einer Unterseite des Trägersubstrats angeordnet.

Gemäß einer Weiterbildung umfasst der Gesamtstapel ein Trägersubstrat, wobei die Unterseite des ersten Stapels stoffschlüssig mit der Oberseite des Trägersubstrats oder mit einer die Oberseite des Trägersubstrats vollständig überdeckenden leitfähigen Zwischenschicht verbunden ist.

Bevorzugt bildet das Trägersubstrat in einer Projektion senkrecht zu der Oberseite des ersten Stapels einen umlaufenden Rand um den ersten Stapel herum aus. Anders ausgedrückt durch den umlaufenden Rand bildet sich ein eine Stufe mit einer Stufenfläche aus. In einer weiteren Weiterbildung ist eine dritte Kontaktfläche auf dem umlaufenden Rand des Trägersubstrats bzw. auf der Stufenfläche angeordnet.

Vorzugsweise ist an der Unterseite des Trägersubstrats eine ganzflächige Kontaktschicht als dritte Kontaktfläche ausgebildet. In einer Weiterbildung ist die dritte Kontaktfläche mit einer Anode der an die Unterseite des ersten Stapels angrenzenden Halbleiterdiode elektrisch leitfähig verbunden.

In einer anderen Weiterbildung ist zwischen jeweils zwei aufeinanderfolgenden Halbleiterdioden des ersten Teilstapels eine Tunneldiode ausgebildet.

In einer Ausführungsform weisen wenigstens zwei Halbleiterdioden (D1, D2, DN) des ersten Stapels (ST1) eine identische Abfolge von Halbleiterschichten auf, wobei die jeweiligen zueinander korrespondieren Schichten der beiden Halbleiterdioden (D1, D2, DN) eine identische Stöchiometrie aufweisen.

In einer Weiterbildung weist die weitere Halbleiterdiode (Dpin) eine Abfolge von stapelförmig angeordneten Halbleiterschichten auf, wobei die Abfolge identisch oder nicht Identisch zu der Abfolge der Halbleiterschichten von einer der Halbleiterdioden (D1, D2, DN) des ersten Stapels ist. Vorzugsweise weisen bei der Identität, die jeweils zueinander korrespondieren Schichten der beiden Halbleiterdioden (D1, D2, DN, DPIN) eine identische Stöchiometrie auf.

In einer Weiterbildung weist die weitere Diode eine Grenzfrequenz oberhalb von 250 kHz auf. Vorzugsweise liegt die Grenzfrequenz in einem Bereich zwischen 1 MHz und 1 GHz, höchst vorzugsweise liegt die Grenzfrequenz in einem Bereich zwischen 2 MHz und 100 MHz

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: ein Schaltbild einer erste erfindungsgemäßen Ausführungsform einer optischen Spannungsquelle und einer Auskoppelvorrichtung,
- Figur 2: eine schematische Schnittansicht einer ersten erfindungsgemäßen Ausführungsform der Spannungsquelle und Teilen der Auskoppelvorrichtung der Figur 1,
- Figur 3: eine schematische Aufsicht auf die Ausführungsform der Figur 2.

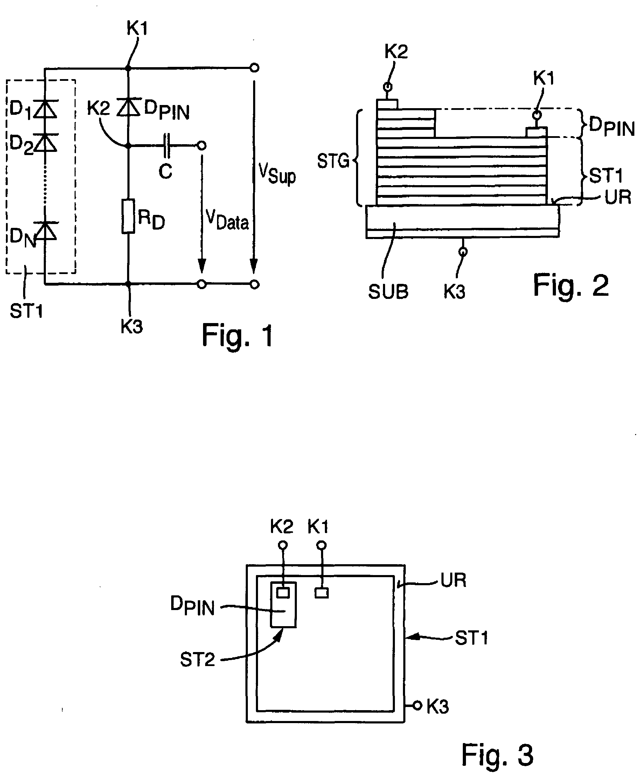

Die Abbildung der Figur 1 zeigt schematisch ein Schaltbild einer ersten Ausführungsform einer optischen Spannungsquelle und einer Auskoppelvorrichtung.

Die optische Spannungsquelle umfasst eine Anzahl N von zueinander in Serie geschalteten Halbleiterdiode D1, D2 bis DN. Die Halbleiterdioden D1, D2, und DN bilden einen ersten Stapel ST1 aus. Auf dem ersten Stapel ST1 ist ein zweiter Stapel ST2 angeordnet. Die zweite Stapel ST2 umfasst eine weitere Halbleiterdiode DPIN. Vorzugsweise sind der erste Stapel ST1 und der zweite Stapel ST2 monolithisch integriert.

Die Auskoppelvorrichtung umfasst die weitere Halbleiterdiode DPIN und ein RC-Glied aus einem Widerstand R_{D} und einem Kondensator C zum Abgreifen eines Datensignals Vdata. Die weitere Halbleiterdiode DPIN ist über einen ersten elektrischen Kontakt K1 zu den Halbleiterdioden D1, D2 bis DN antiseriell verschaltet, d.h. die Kathode der weiteren Halbleiterdiode und die Kathode der obersten Halbleiterdiode D1 des ersten Stapels ST1 sind elektrisch leitfähig mit dem ersten Kontaktpunkt K1 verbunden.

Die Anode der untersten Halbleiterdiode DN des ersten Stapels ST1 ist elektrisch leitfähig mit einem dritten elektrischen Kontakt K3 verbunden. Die Anode der weiteren Halbleiterdiode Dpin ist über einen zweiten elektrischen Kontakt K2 und den Widerstand R_{D} mit dem dritten Kontakt K3 elektrisch leitfähig verbunden, wodurch die weitere Halbleiterdiode Dpin durch eine Quellspannung Vsup der optischen Spannungsquelle in Sperrrichtung vorgespannt wird.

Über einen Kondensator C wird an dem zweiten Kontakt K2 gegenüber dem dritten Kontakt K3 ein Datensignal Vdata abgegriffen.

In der Abbildung der Figur 2 ist eine erste Ausführungsform der optischen Spannungsquelle mit Teilen der Auskopplungsvorrichtung als integriertes Bauteil dargestellt. Die Abbildung der Figur 3 zeigt eine Aufsicht auf das integrierte Bauteil gemäß der Ausführungsform der Figur 2. Im Folgenden werden nur die Unterschiede zu der Abbildung der Figur 1 erläutert.

Die N zueinander in Serie geschalteten Halbleiterdiode D1, D2 bis DN bilden einen ersten Stapel ST1. Auf einer Oberseite des ersten Stapels ST1 sind zueinander beabstandet die weitere Diode Dpin und eine Kontaktfläche als erster Kontakt K1 angeordnet. Die weitere Diode Dpin ist mit einer Unterseite stoffschlüssig mit der Oberseite des ersten Stapels ST1 verbunden und bildet mit dem ersten Stapel ST1 zusammen eine Gesamtstapel STG aus. Auf einer Oberseite der weiteren Diode Dpin ist eine zweite Kontaktfläche K2 angeordnet.

Eine Unterseite des ersten Stapels ST1 ist stoffschlüssig mit einer Oberseite eines Trägersubstrats SUB als weitere Schicht des Gesamtstapels STG verbunden, wobei das Trägersubstrat SUB in einer Projektion senkrecht zu der Oberseite des ersten Stapels einen umlaufenden Rand UR um den ersten Stapel ST1 herum ausbildet. Eine leitfähige Beschichtung überdeckt als dritter Kontakt K3 eine Unterseite des Trägersubstrats SUB.

Weitere Komponenten, wie das RC-Glied aus Figur 1 werden gemäß dieser Ausführungsform extern realisiert.

## Patentansprüche

1. Optische Spannungsquelle und Auskoppelvorrichtung, wobei
- die optische Spannungsquelle eine Anzahl N zueinander in Serie geschalteter Halbleiterdiode (D1, DN) jeweils mit einem p-n Übergang aufweist,
- die Halbleiterdioden (D1, D2, DN) zusammen monolithisch integriert sind und gemeinsam einen ersten Stapel (ST1) mit einer Oberseite und einer Unterseite ausbilden, und
- die Anzahl N der Halbleiterdioden (D1, D2, DN) des ersten Stapels (ST1) größer gleich zwei ist,
**dadurch gekennzeichnet, dass**
- die Auskoppelvorrichtung einen zweiten Stapel (ST2) mit einer weiteres Halbleiterdiode (Dpin) aufweist,
- die weitere Halbleiterdiode (Dpin) einen p-i-n-Übergang aufweist,
- die weitere Halbleiterdiode (Dpin) mit den Halbleiterdioden (D1, D2, DN) des ersten Stapels (ST1) anti-seriell geschaltet ist,
- eine Unterseite der weiteren Halbleiterdiode (Dpin) mit der Oberseite des ersten Stapels (ST1) stoffschlüssig verbunden ist und
- der zweite Stapel (ST2) mit der weiteren Halbleiterdiode (Dpin) mit dem ersten Stapel (ST1) zusammen einen Gesamtstapel (STG) ausbilden.

2. Optische Spannungsquelle und Auskoppelvorrichtung nach Anspruch 1, **dadurch gekennzeichnet, dass** die weitere Halbleiterdiode (Dpin) in einer Projektion senkrecht zu der Oberseite des ersten Stapels (ST1) höchstens 50% oder höchstens 30% oder höchstens 10% der Oberseite des ersten Stapels (ST1) überdeckt.

3. Optische Spannungsquelle und Auskoppelvorrichtung nach Anspruch 1 oder 2, **dadurch gekennzeichnet, dass** die weitere Halbleiterdiode (Dpin) eine Kapazität von höchstens 10 pF aufweist.

4. Optische Spannungsquelle und Auskoppelvorrichtung nach einem der Ansprüche 1 bis 3, **dadurch gekennzeichnet, dass** die Halbleiterdioden (D1, D2, DN) und die weitere Halbleiterdiode (Dpin) zusammen monolithisch integriert sind.

5. Optische Spannungsquelle und Auskoppelvorrichtung nach einem der Ansprüche 1 bis 4, **dadurch gekennzeichnet, dass** ein erster elektrischer Kontakt (K1) auf der Oberseite des ersten Stapels (ST1) angeordnet ist und einen Abstand zu der weiteren Diode (Dpin) aufweist.

6. Optische Spannungsquelle und Auskoppelvorrichtung nach Anspruch 5, **dadurch gekennzeichnet, dass** der erste Kontakt (K1) mit einer Kathode der weiteren Halbleiterdiode (Dpin) und mit einer Kathode der an die Oberseite des ersten Stapels (ST1) angrenzenden Halbleiterdiode (D1) elektrisch leitfähig verbunden ist.

7. Optische Spannungsquelle und Auskoppelvorrichtung nach einem der Ansprüche 1 bis 6, **dadurch gekennzeichnet, dass** ein zweiter Kontakt (K2) auf einer Oberseite der weiteren Diode (Dpin) angeordnet ist.

8. Optische Spannungsquelle und Auskoppelvorrichtung nach einem der Ansprüche 1 bis 7, **dadurch gekennzeichnet, dass** eine dritte Kontaktfläche (K3) auf einer Unterseite des ersten Stapels (ST1) angeordnet ist oder dass eine Unterseite des erste Stapel (ST1) stoffschlüssig mit einer Oberseite eines Trägersubstrats (SUB) verbunden und ein dritter Kontakt (K3) auf einer Unterseite des Trägersubstrats (SUB) angeordnet ist.

9. Optische Spannungsquelle und Auskoppelvorrichtung nach einem der Ansprüche 1 bis 8, **dadurch gekennzeichnet, dass** der Gesamtstapel (STG) ein Trägersubstrat (SUB) umfasst, wobei die Unterseite des ersten Stapels (ST1) stoffschlüssig mit einer Oberseite des Trägersubstrats (SUB) oder mit einer eine Oberseite des Trägersubstrats (SUB) vollständig überdeckenden leitfähigen Zwischenschicht verbunden ist.

10. Optische Spannungsquelle und Auskoppelvorrichtung nach Anspruch 9, **dadurch gekennzeichnet, dass** das Trägersubstrat (SUB) in einer Projektion senkrecht zu der Oberseite des ersten Stapels (ST1) einen umlaufenden Rand (UR) um den ersten Stapel (ST1) herum ausbildet.

11. Optische Spannungsquelle und Auskoppelvorrichtung nach Anspruch 10, **dadurch gekennzeichnet, dass** eine dritte Kontaktfläche auf dem umlaufenden Rand (UR) des Trägersubstrats (SUB) angeordnet ist.

12. Optische Spannungsquelle und Auskoppelvorrichtung nach Anspruch 8 oder 11, **dadurch gekennzeichnet, dass** der dritte Kontakt (K3) mit einer Anode der an die Unterseite des ersten Stapels (ST1) angrenzenden Halbleiterdiode (DN) elektrisch leitfähig verbunden ist.

13. Optische Spannungsquelle und Auskoppelvorrichtung nach einem der Ansprüche 1 bis 12, **dadurch gekennzeichnet, dass** die Halbleiterdioden (D1, D2, DN) des ersten Stapels (ST1) und/oder die weitere Halbleiterdiode (Dpin) ein III-V-Halbleitermaterial umfassen oder aus einem III-V-Halbleitermaterial bestehen.

14. Optische Spannungsquelle und Auskoppelvorrichtung nach Anspruch 13, **dadurch gekennzeichnet, dass** das III-V-Halbleitermaterial GaAs ist.

15. Optische Spannungsquelle und Auskoppelvorrichtung nach einem der Ansprüche 1 bis 14, **dadurch gekennzeichnet, dass** zwischen jeweils zwei aufeinanderfolgenden Halbleiterdioden (D1, D2, DN) des ersten Teilstapels (ST1) eine Tunneldiode ausgebildet Ist.

16. Optische Spannungsquelle und Auskoppelvorrichtung nach einem der Ansprüche 1 bis 15, **dadurch gekennzeichnet, dass** wenigstens zwei Halbleiterdioden (D1, D2, DN) des ersten Stapels (ST1) eine identische Abfolge von Halbleiterschichten aufweisen, wobei die jeweiligen zueinander korrespondieren Schichten der beiden Halbleiterdioden (D1, D2, DN) eine identische Stöchiometrie aufweisen.

17. Optische Spannungsquelle und Auskoppelvorrichtung nach einem der Ansprüche 1 bis 16, **dadurch gekennzeichnet, dass** die weitere Halbleiterdiode (Dpin) eine Abfolge von stapelförmig angeordneten Halbleiterschichten aufweist und die Abfolge identisch oder nicht identisch zu der Abfolge der Halbleiterschichten von einer der Halbleiterdioden (D1, D2, DN) des ersten Stapels ist.

18. Optische Spannungsquelle und Auskoppelvorrichtung nach einem der Ansprüche 1 bis 17, **dadurch gekennzeichnet, dass** die weitere Halbleiterdiode (Dpin) eine Grenzfrequenz von oberhalb von 250 kHz aufweist.

## Claims

1. Optical voltage source and decoupling device, wherein
- the optical voltage source comprises a number N of serially connected semiconductor diodes (D1, DN) each with a p-n transition,
- the semiconductor diodes (D1, D2, DN) are monolithically integrated together and together form a first stack (ST1) with an upper side and a lower side and
- the number N of the semiconductor diodes (D1, D2, DN) of the first stack (ST1) is equal to or greater than two,
**characterised in that**
- the decoupling device comprises a second stack (ST2) with a further semiconductor diode (Dpin),
- the further semiconductor diode (Dpin) has a p-i-n transition,
- the further semiconductor diode (Dpin) is anti-serially connected with the semiconductor diodes (D1, D2, DN) of the first stack (ST1),
- a lower side of the further semiconductor diode (Dpin) is connected by material couple with the upper side of the first stack (ST1) and
- the second stack (ST2) with the further semiconductor diode (Dpin) forms, together with the first stack (ST1), an overall stack (STG).

2. Optical voltage source and decoupling device according to claim 1, **characterised in that** the further semiconductor diode (Dpin) in a projection perpendicular to the upper side of the first stack (ST1) covers at most 50% or at most 30% or at most 10% of the upper side of the first stack (ST1).

3. Optical voltage source and decoupling device according to claim 1 or 2, **characterised in that** the further semiconductor diode (Dpin) has a capacitance of at most 10 pF.

4. Optical voltage source and decoupling device according to any one of claims 1 to 3, **characterised in that** the semiconductor diodes (D1, D2, DN) and the further semiconductor diode (Dpin) are monolithically integrated together.

5. Optical voltage source and decoupling device according to any one of claims 1 to 4, **characterised in that** a first electrical contact (K1) is arranged on the upper side of the first stack (ST1) and has a spacing from the further diode (Dpin).

6. Optical voltage source and decoupling device according to claim 5, **characterised in that** the first contact (K1) is electrically conductively connected with a cathode of the further semiconductor diode (Dpin) and with a cathode of the semiconductor diode (D1) adjoining the upper side of the first stack (ST1).

7. Optical voltage source and decoupling device according to any one of claims 1 to 6, **characterised in that** a second contact (K2) is arranged on an upper side of the further diode (Dpin).

8. Optical voltage source and decoupling device according to any one of claims 1 to 7, **characterised in that** a third contact area (K3) is arranged on a lower side of the first stack (ST1) or that a lower side of the first stack (ST1) is connected by material couple with an upper side of a carrier substrate (SUB) and a third contact (K3) is arranged on a lower side of the carrier substrate (SUB).

9. Optical voltage source and decoupling device according to any one of claims 1 to 8, **characterised in that** the overall stack (STG) comprises a carrier substrate (SUB), wherein the lower side of the first stack (ST1) is connected by material couple with an upper side of the carrier substrate (SUB) or with a conductive intermediate layer completely covering an upper side of the carrier substrate (SUB).

10. Optical voltage source and decoupling device according to claim 9, **characterised in that** the carrier substrate (SUB) in a projection perpendicular to the upper side of the first stack (ST1) forms an encircling edge (UR) around the first stack (ST1).

11. Optical voltage source and decoupling device according to claim 10, **characterised in that** a third contact area is arranged on the encircling edge (UR) of the carrier substrate (SUB).

12. Optical voltage source and decoupling device according to claim 8 or 11, **characterised in that** the third contact (K3) is electrically conductively connected with an anode of the semiconductor diode (DN) adjoining the lower side of the first stack (ST1).

13. Optical voltage source and decoupling device according to any one of claims 1 to 12, **characterised in that** the semiconductor diodes (D1, D2, DN) of the first stack (ST1) and/or the further semiconductor diode (Dpin) comprises or comprise a III-V semiconductor material or consists or consist of a III-V semiconductor material.

14. Optical voltage source and decoupling device according to claim 13, **characterised in that** the III-V semiconductor material is GaAs.

15. Optical voltage source and decoupling device according to any one of claims 1 to 14, **characterised in that** a tunnel diode is formed between each two successive semiconductor diodes (D1, D2, DN) of the first part stack (ST1).

16. Optical voltage source and decoupling device according to any one of claims 1 to 15, **characterised in that** at least two semiconductor diodes (D1, D2, DN) of the first stack (ST1) have an identical sequence of semiconductor layers, wherein the respective mutually corresponding layers of the two semiconductor diodes (D1, D2, DN) have an identical stoichiometry.

17. Optical voltage source and decoupling device according to any one of claims 1 to 16, **characterised in that** the further semiconductor diode (Dpin) comprises a sequence of semiconductor layers arranged in stack form and the sequence is identical or non-identical with the sequence of the semiconductor layers of one of the semiconductor diodes (D1, D2, DN) of the first stack.

18. Optical voltage source and decoupling device according to any one of claims 1 to 17, **characterised in that** the further semiconductor diode (Dpin) has a limit frequency of above 250 kHz.

## Revendications

1. Source de tension optique et dispositif de découplage, dans laquelle
- la source de tension optique présente un nombre N de diodes à semi-conducteur (D1, DN) chacune avec une transition p-n connectées en série l'une à l'autre,
- les diodes à semi-conducteur (D1, D2, DN) sont intégrées de façon monolithique l'une à l'autre et forment ensemble un premier empilement (ST1) avec un côté supérieur et un côté inférieur, et
- le nombre N de diodes à semi-conducteur (D1, D2, DN) du premier empilement (ST1) est supérieur ou égal à deux,
**caractérisée en ce que**
- le dispositif de découplage présente un second empilement (ST2) avec une autre diode à semi-conducteur (Dpin),
- l'autre diode à semi-conducteur (Dpin) présente une transition p-i-n,
- l'autre diode à semi-conducteur (Dpin) est connectée en anti-série avec les diodes à semi-conducteur (D1, D2, DN) du premier empilement (ST1),
- un côté inférieur de l'autre diode à semi-conducteur (Dpin) est matériellement assemblé au côté supérieur du premier empilement (ST1) et
- le second empilement (ST2) avec l'autre diode à semi-conducteur (Dpin) forme avec le premier empilement (ST1) un empilement total (STG).

2. Source de tension optique et dispositif de découplage selon la revendication 1, **caractérisée en ce que** l'autre diode à semi-conducteur (Dpin) recouvre, dans une projection perpendiculaire au côté supérieur du premier empilement (ST1), au maximum 50 % ou au maximum 30 % ou au maximum 10 % du côté supérieur du premier empilement (ST1).

3. Source de tension optique et dispositif de découplage selon une revendication 1 ou 2, **caractérisée en ce que** l'autre diode à semi-conducteur (Dpin) présente une capacité de 10 pF au maximum.

4. Source de tension optique selon l'une quelconque des revendications 1 à 3, **caractérisée en ce que** les diodes à semi-conducteur (D1, D2, DN) et l'autre diode à semi-conducteur (Dpin) sont intégrées ensemble de façon monolithique.

5. Source de tension optique et dispositif de découplage selon l'une quelconque des revendications 1 à 4, **caractérisée en ce qu'**un premier contact électrique (K1) est disposé sur le côté supérieur du premier empilement (ST1) et présente une distance de l'autre diode (Dpin).

6. Source de tension optique et dispositif de découplage selon la revendication 5, **caractérisée en ce que** le premier contact (K1) est connecté en liaison électriquement conductrice à une cathode de l'autre diode à semi-conducteur (Dpin) et à une cathode de la diode à semi-conducteur (D1) adjacente au côté supérieur du premier empilement (ST1).

7. Source de tension optique et dispositif de découplage selon l'une quelconque des revendications 1 à 6, **caractérisée en ce qu'**un deuxième contact (K2) est disposé sur un côté supérieur de l'autre diode (Dpin).

8. Source de tension optique et dispositif de découplage selon l'une quelconque des revendications 1 à 7, **caractérisée en ce qu'**une troisième face de contact (K3) est disposée sur un côté inférieur du premier empilement (ST1) ou **en ce qu'**un côté inférieur du premier empilement (ST1) est matériellement assemblé à un côté supérieur d'un substrat de support (SUB) et un troisième contact (K3) est disposé sur un côté inférieur du substrat de support (SUB).

9. Source de tension optique et dispositif de découplage selon l'une quelconque des revendications 1 à 8, **caractérisée en ce que** l'empilement total (STG) comprend un substrat de support (SUB), dans lesquels le côté inférieur du premier empilement (ST1) est matériellement assemblé à un côté supérieur du substrat de support (SUB) ou à une couche intermédiaire conductrice recouvrant entièrement un côté supérieur du substrat de support (SUB).

10. Source de tension optique et dispositif de découplage selon la revendication 9, **caractérisée en ce que** le substrat de support (SUB) forme, dans une projection perpendiculaire sur le côté supérieur du premier empilement (ST1), un bord périphérique (UR) autour du premier empilement (ST1).

11. Source de tension optique et dispositif de découplage selon la revendication 10, **caractérisée en ce qu'**une troisième face de contact est disposée sur le bord périphérique (UR) du substrat de support (SUB).

12. Source de tension optique et dispositif de découplage selon la revendication 8 ou 11, **caractérisée en ce que** le troisième contact (K3) est connecté en liaison électriquement conductrice à une anode de la diode à semi-conducteur (DN) adjacente au côté inférieur du premier empilement (ST1).

13. Source de tension optique et dispositif de découplage selon l'une quelconque des revendications 1 à 12, **caractérisée en ce que** les diodes à semi-conducteur (D1, D2, DN) du premier empilement (ST1) et/ou l'autre diode à semi-conducteur (Dpin) comprennent un matériau semi-conducteur des groupes III-V ou sont constituées d'un matériau semi-conducteur des groupes III-V.

14. Source de tension optique et dispositif de découplage selon la revendication 13, **caractérisée en ce que** le matériau semi-conducteur des groupes III-V est le GaAs.

15. Source de tension optique et dispositif de découplage selon l'une quelconque des revendications 1 à 14, **caractérisée en ce qu'**une diode tunnel est formée chaque fois entre deux diodes à semi-conducteur successives (D1, D2, DN) du premier empilement (ST1).

16. Source de tension optique et dispositif de découplage selon l'une quelconque des revendications 1 à 15, **caractérisée en ce qu'**au moins deux diodes à semi-conducteur (D1, D2, DN) du premier empilement (ST1) présentent une succession identique de couches de semi-conducteur, les couches des deux diodes à semi-conducteur (D1, D2, DN) se correspondant respectivement l'une à l'autre présentant une stœchiométrie identique.

17. Source de tension optique et dispositif de découplage selon l'une quelconque des revendications 1 à 16, **caractérisée en ce que** l'autre diode à semi-conducteur (Dpin) présente une succession de couches de semi-conducteur disposées sous forme empilée et la succession est identique ou n'est pas identique à la succession des couches de semi-conducteur d'une des diodes à semi-conducteur (D1, D2, DN) du premier empilement.

18. Source de tension optique et dispositif de découplage selon l'une quelconque des revendications 1 à 17, **caractérisée en ce que** l'autre diode à semi-conducteur (Dpin) présente une fréquence limite supérieure à 250 kHz.
